# EUROPÄISCHE PATENTSCHRIFT

(11) **EP 4 211 719 B1**
(45) Veröffentlichungstag und Bekanntmachung des Hinweises auf die Patenterteilung: **04.03.2026**
(21) Anmeldenummer: 21806190.1
(22) Anmeldetag: 03.11.2021
(51) Int. Cl.: H01L 23/367, H01L 23/373, H01L 23/498, H01L 23/40

(54) **HALBLEITERMODUL MIT ZUMINDEST EINEM HALBLEITERELEMENT**
SEMICONDUCTOR MODULE WITH AT LEAST ONE SEMICONDUCTOR ELEMENT
MODULE SEMI-CONDUCTEUR POURVU D'AU MOINS UN ÉLÉMENT SEMI-CONDUCTEUR

(30) Priorität: 09.12.2020 EP 20212848
(43) Veröffentlichungstag der Anmeldung: 19.07.2023
(73) Patentinhaber: Siemens Aktiengesellschaft, 80333 München (DE)
(72) Erfinder: PFEFFERLEIN, Stefan, 90562 Heroldsberg (DE); ZEYSS, Felix, 91052 Erlangen (DE)
(74) Vertreter: Siemens Patent Attorneys
(86) Internationale Anmeldenummer: PCT/EP2021/080533
(87) Internationale Veröffentlichungsnummer: WO 2022/122256

(56) Entgegenhaltungen:
- WO-A1-2019/025314
- CN-A- 111 863 775
- US-A1- 2013 299 962
- US-A1- 2019 355 644

## Beschreibung

Die Erfindung betrifft ein Halbleitermodul mit zumindest einem Halbleiterelement.

Ferner betrifft die Erfindung einen Stromrichter mit mindestens einem derartigen Halbleitermodul.

Darüber hinaus betrifft die Erfindung ein Verfahren zur Herstellung eines Halbleitermoduls mit zumindest einem Halbleiterelement.

Derartige Halbleitermodule kommen in der Regel in einem Stromrichter zum Einsatz. Unter einem Stromrichter ist beispielsweise ein Gleichrichter, ein Wechselrichter, ein Umrichter oder ein Gleichspannungswandler zu verstehen. Derartige Halbleitermodule werden beispielsweise mittels einer planaren Aufbau- und Verbindungstechnik realisiert.

Die Offenlegungsschrift WO 2018/202439 A1 beschreibt eine elektronische Baugruppe mit einem Bauelement, welches zwischen einem ersten Substrat und einem zweiten Substrat gehalten ist. Erfindungsgemäß ist vorgesehen, dass ein Spalt zwischen dem ersten Substrat und dem Bauelement mit einem Durchgangsloch verbunden ist, so dass durch das Durchgangsloch hindurch beispielsweise ein Lotwerkstoff unter Ausnutzung von im Durchgangsloch und im Spalt wirkenden Kapillarkräften dosiert werden kann. Dabei erfolgt die Dosierung automatisch, da die Kapillarkräfte nur im Spalt wirken. Vorteilhaft lässt sich durch die automatische Dosierung des Lotwerkstoffs ein Toleranzausgleich bewerkstelligen, der aufgrund unterschiedlicher Spaltmaße notwendig werden kann.

Die Offenlegungsschrift WO 2019/015901 A1 beschreibt eine elektrische Baugruppe, die wenigstens ein elektronisches Schaltelement aufweist, das an seiner Unterseite und an seiner dieser gegenüberliegenden Oberseite elektrisch kontaktiert ist. Die elektrische Baugruppe weist zudem zwei einander gegenüberliegend an den elektrischen Kontaktierungen angeordnete Verdrahtungsträger auf. Diese Verdrahtungsträger sind jeweils wenigstens zum Teil aus einem dauerelastischen, elektrisch isolierenden, thermisch leitfähigen Material gebildet.

Die Offenlegungsschrift US 2019/355644 A1 beschreibt ein IGBT-Modul mit einer Wärmeableitungsgrundplatte.

Die Offenlegungsschrift US 2013/299962 A1 beschreibt eine Halbleitervorrichtung mit einem IGBT als vertikales Halbleiterelement, der zwischen einem ersten und einem zweiten Leadframe paarweise vorgesehen ist.

Bei einer derartigen planaren Aufbau- und Verbindungstechnik ist eine Integration von, insbesondere zusätzlichen, Wärmekapazitäten, durch den flachen Aufbau nur schwer umsetzbar. Derartige Wärmekapazitäten werden insbesondere bei hohen und kurzzeitigen Überlastanforderungen benötigt, um z.B. Chiptemperaturhübe klein zu halten.

Vor diesem Hintergrund besteht die Aufgabe der vorliegenden Erfindung darin, ein Halbleitermodul anzugeben, welches, im Vergleich zum Stand der Technik, eine höhere Zuverlässigkeit aufweist.

Die Aufgabe wird erfindungsgemäß durch ein Halbleitermodul mit zumindest einem Halbleiterelement, einem ersten Substrat und einem zweiten Substrat, wobei das zumindest eine Halbleiterelement auf einer ersten Seite flächig mit dem ersten Substrat und auf einer der ersten Seite abgewandten zweiten Seite flächig mit einer metallischen Wärmesenke kontaktiert ist, wobei die metallische Wärmesenke mit dem Halbleiterelement in einer thermisch leitenden Verbindung steht und elektrisch leitend mit dem zweiten Substrat verbunden ist, wobei die metallische Wärmesenke einen Grundkörper zur flächigen Kontaktierung des Halbleiterelements und zumindest eine Rippe aufweist, wobei das zweite Substrat elektrisch leitend mit dem Grundkörper verbunden ist und eine Aussparung aufweist, in welcher die zumindest eine Rippe angeordnet ist, wobei der Grundkörper eine um die zumindest eine Rippe umlaufende Kontaktfläche aufweist, über welche eine stoffschlüssige Verbindung mit der Substratmetallisierung des zweiten Substrats hergestellt ist, wobei die umlaufendende Kontaktfläche auf einer dem Halbleiterelement abgewandten Seite des Grundkörpers angeordnet ist.

Ferner wird die Aufgabe erfindungsgemäß gelöst durch einen Stromrichter mit mindestens einem derartigen Halbleitermodul. Darüber hinaus wird die Aufgabe erfindungsgemäß gelöst durch ein Verfahren zur Herstellung eines Halbleitermoduls mit zumindest einem Halbleiterelement, einem ersten Substrat und einem zweiten Substrat, wobei das zumindest eine Halbleiterelement auf einer ersten Seite flächig mit dem ersten Substrat und auf einer der ersten Seite abgewandten zweiten Seite flächig mit einer metallischen Wärmesenke kontaktiert wird, wobei eine thermisch leitende Verbindung zwischen der metallischen Wärmesenke und dem Halbleiterelement hergestellt wird und die metallische Wärmesenke elektrisch leitend mit dem zweiten Substrat verbunden wird, wobei die metallische Wärmesenke einen Grundkörper zur flächigen Kontaktierung des Halbleiterelements und zumindest eine Rippe aufweist, wobei das zweite Substrat elektrisch leitend mit dem Grundkörper verbunden wird und eine Aussparung aufweist, in welcher die zumindest eine Rippe angeordnet wird, wobei der Grundkörper eine um die zumindest eine Rippe umlaufende Kontaktfläche aufweist, über welche eine stoffschlüssige Verbindung mit der Substratmetallisierung des zweiten Substrats hergestellt wird, wobei die umlaufendende Kontaktfläche auf einer dem Halbleiterelement abgewandten Seite des Grundkörpers angeordnet wird.

Die in Bezug auf das Halbleitermodul nachstehend angeführten Vorteile und bevorzugten Ausgestaltungen lassen sich sinngemäß auf den Stromrichter und das Herstellungsverfahren übertragen.

Der Erfindung liegt die Überlegung zugrunde, die Zuverlässigkeit eines Halbleitermoduls durch eine chipnahe metallische Wärmesenke, auch Wärmekapazität genannt, zu erhöhen. Das Halbleitermodul weist zumindest ein Halbleiterelement, ein erstes Substrat und ein zweites Substrat auf, wobei das zumindest eine Halbleiterelement auf einer ersten Seite flächig mit dem ersten Substrat und auf einer der ersten Seite abgewandten zweiten Seite flächig mit der metallischen Wärmesenke kontaktiert ist. Das zweite Substrat ist elektrisch leitend mit der metallischen Wärmesenke verbunden und somit über die metallische Wärmesenke mit dem Halbleiterelement kontaktiert. Ein derartiges Halbleiterelement ist beispielsweise als Transistor, als Diode oder als Logikbaustein ausgeführt. Insbesondere ist der Transistor als Insulated-Gate-BipolarTransistor (IGBT), Metalloxide-Semiconductor-Field-Effect-Transistor (MOSFET) oder Feldeffekttransistor ausgeführt. Die metallische Wärmesenke ist beispielsweise aus, insbesondere massivem, Kupfer und/oder einer Kupferlegierung hergestellt. Die Kontaktierung des Halbleiterelements erfolgt beispielsweise über eine elektrisch leitfähige Wärmeleitpaste oder über eine stoffschlüssige Verbindung. Durch die Kontaktierung steht die metallische Wärmesenke mit dem Halbleiterelement in einer thermisch leitenden Verbindung, sodass im Halbleitermodul entstehende Verlustwärme zumindest teilweise an die metallische Wärmesenke übertragen wird. In der metallischen Wärmesenke wird die Verlustwärme beispielsweise gespeichert und/oder an die umgebende Atmosphäre abgegeben. Die umgebende Atmosphäre ist beispielsweise Luft oder ein Kühlfluid. Durch eine derartige Anordnung mit einer metallischen Wärmesenke können Chiptemperaturhübe auch bei hohen und kurzzeitigen Überlasten klein gehalten werden, was zu einer Verbesserung der Zuverlässigkeit des Halbleitermoduls führt.

Die metallische Wärmesenke weist einen Grundkörper zur flächigen Kontaktierung des Halbleiterelements und zumindest eine Rippe auf, wobei das zweite Substrat elektrisch leitend mit dem Grundkörper verbunden ist und eine Aussparung aufweist, in welcher die zumindest eine Rippe angeordnet ist. Der Grundkörper weist beispielsweise eine rechteckige Kontaktfläche auf. Durch die flächige Kontaktierung des Grundkörpers wird ein optimaler Wärmeübergang erreicht. Die zumindest eine Rippe kann bündig mit dem zweiten Substrat abschließen oder über das zweite Substrat hinausstehen. Insbesondere ist die zumindest eine Rippe quaderförmig oder zylinderförmig ausgeführt, um eine möglichst große Wärmekapazität zu erreichen.

Der Grundkörper weist eine um die zumindest eine Rippe umlaufendende Kontaktfläche auf, über welche eine stoffschlüssige Verbindung mit der Substratmetallisierung des zweiten Substrats hergestellt ist. Insbesondere ist die Kontaktfläche umlaufend um die Aussparung des zweiten Substrats ausgeführt. Beispielsweise ist die Kontaktfläche als umlaufender Lötring ausgeführt. Eine derartige umlaufendende Kontaktfläche ermöglicht eine gleichmäßige Wärmeverteilung, sodass Hotspots vermieden werden.

Die umlaufende Kontaktfläche ist auf einer dem Halbleiterelement abgewandten Seite des Grundkörpers angeordnet. Durch eine derartige Anordnung der umlaufendenden Kontaktfläche liegt das zweite Substrat zumindest teilweise auf dem Grundkörper auf, was zu einer mechanischen Stabilisierung der Anordnung und einer Vergrößerung der Kontaktfläche führt.

Die Aussparung des zweiten Substrats weist eine, insbesondere umlaufende, Kantenmetallisierung auf, über welche eine stoffschlüssige Verbindung zur metallischen Wärmesenke hergestellt ist. Über die Kantenmetallisierung kann beispielsweise durch eine Kapillarwirkung ein Lot des umlaufenden Lötrings hochsteigen, was zu einer Vergrößerung der Anbindungsfläche der metallischen Wärmesenke zum zweiten Substrat führt, was die thermische Anbindung an die metallischen Wärmesenke verbessert.

Eine weitere Ausführungsform sieht vor, dass das Halbleiterelement stoffschlüssig mit der metallischen Wärmesenke verbunden ist und/oder wobei die metallische Wärmesenke stoffschlüssig mit einer Substratmetallisierung des zweiten Substrats verbunden ist. Eine derartige stoffschlüssige Verbindung ist beispielsweise als eine Löt- oder Sinterverbindung ausgeführt, was zu einer verbesserten thermischen Anbindung führt.

Eine weitere Ausführungsform sieht vor, dass das Halbleiterelement in einem Vergussraum zwischen dem ersten Substrat und dem zweiten Substrat angeordnet ist und wobei der Vergussraum durch die stoffschlüssige Verbindung zwischen der Substratmetallisierung des zweiten Substrats und der umlaufenden Kontaktfläche zur Aussparung hin abgedichtet ist. Der Vergussraum umfasst beispielsweise einen, insbesondere isolierenden, Verguss, welcher z.B. Silikon enthält und zur Einhaltung der erforderlichen Spannungsabstände und zum Schutz vor schädlichen Umwelteinflüssen dient. Durch die stoffschlüssige Verbindung mit der umlaufenden Kontaktfläche sind keine zusätzlichen Dichtungselemente erforderlich.

Eine weitere Ausführungsform sieht vor, dass die metallische Wärmesenke einstückig aus einem metallischen Werkstoff mit einer Wärmeleitfähigkeit von mindestens 240 W/(m·K) und/oder einer elektrischen Leitfähigkeit von mindestens 40 MS/m hergestellt ist. Beispielsweise ist die metallische Wärmesenke aus Kupfer oder einer Kupferlegierung hergestellt. Eine einstückige Ausführung aus einem derartigen Werkstoff führt zu einer optimalen thermischen Anbindung.

Eine weitere Ausführungsform sieht vor, dass die metallische Wärmesenke ein T-förmiges Querschnittsprofil aufweist. Insbesondere ist die größere Fläche der metallischen Wärmesenke mit dem T-förmigen Querschnittsprofil zur Kontaktierung des Halbleiterelements vorgesehen. Ein derartiges Querschnittsprofil ermöglicht eine optimale thermische Anbindung an das Halbleiterelement und eine großflächige Kontaktierung des zweiten Substrats, was zu einer Erhöhung der Stromtragfähigkeit und einer Senkung des Übergangswiderstands führt.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausgestaltung eines Halbleitermoduls im Querschnitt,
- FIG 2: eine schematische Darstellung einer zweiten Ausgestaltung eines Halbleitermoduls im Querschnitt,
- FIG 3: eine schematische Darstellung einer dritten Ausgestaltung eines Halbleitermoduls im Querschnitt und
- FIG 4: eine schematische Darstellung eines Stromrichters mit einem Halbleitermodul.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

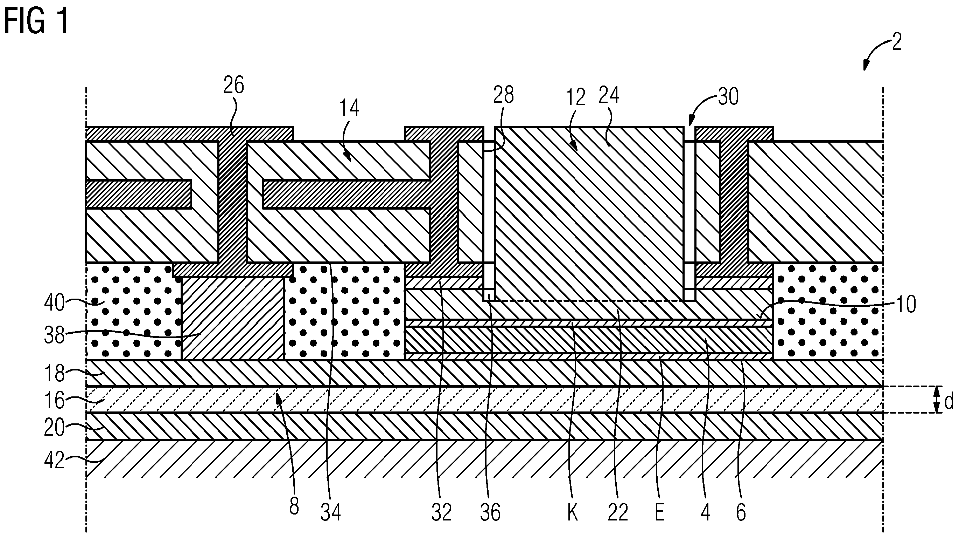

FIG 1 zeigt eine schematische Darstellung einer ersten Ausgestaltung eines Halbleitermoduls 2 im Querschnitt. Das Halbleitermodul 2 umfasst mindestens ein Halbleiterelement 4, das auf einer ersten Seite 6 flächig mit einem ersten Substrat 8 und auf einer der ersten Seite 6 abgewandten zweiten Seite 10 flächig mit einer metallischen Wärmesenke 12 kontaktiert ist. Die metallische Wärmesenke 12 ist mit dem Halbleiterelement 4 thermisch gekoppelt und elektrisch leitend mit dem zweiten Substrat 14 verbunden ist. Die flächige Kontaktierung des Halbleitermoduls 2 mit dem ersten Substrat 8 und der metallischen Wärmesenke 12 wird beispielsweise durch eine stoffschlüssige Verbindung, insbesondere eine Löt- oder Sinterverbindung, hergestellt, wobei durch die stoffschlüssige Verbindung des Halbleitermoduls 2 mit der metallischen Wärmesenke 12 die thermische Kopplung hergestellt ist, sodass im Halbleitermodul 2 entstehende Verlustwärme zumindest teilweise an die metallische Wärmesenke 12 übertragen und dort gespeichert und/oder an die umgebende Atmosphäre, wie z.B. die umgebende Luft oder ein Kühlfluid, abgegeben wird.

Das Halbleiterelement 4 ist exemplarisch als Insulated-Gate-Bipolar-Transistor (IGBT) ausgeführt, kann aber auch als Metalloxide-Semiconductor-Field-Effect-Transistor (MOSFET), als Feldeffekttransistor, als Diode, als Logikbaustein, insbesondere als Field Programmable Gate Array (FPGA) oder als ein anderer Halbleiter ausgeführt sein. Insbesondere weist das Halbleiterelement 4 eine Fläche von mindestens 10 mm2 auf. Beispielsweise ist das als IGBT ausgeführte Halbleiterelement 4 über einen Emitterkontakt E mit dem ersten Substrat 8 und über einen Kollektorkontakt K mit der metallischen Wärmesenke 12 verbunden. Ein Gatekontakt des in FIG 1 dargestellten IGBTs ist aus Gründen der Übersichtlichkeit nicht dargestellt.

Das erste Substrat 8 umfasst eine dielektrische Materiallage 16, die einen keramischen Werkstoff, beispielsweise Aluminiumnitrid oder Aluminiumoxid, oder einen organischen Werkstoff, beispielsweise einem Polyamid enthält und eine Dicke d von 25 µm bis 400 µm, insbesondere 50 µm bis 250 µm, aufweist. Darüber hinaus weist das erste Substrat 8 auf einer dem Halbleiterelement 4 zugewandten Seite eine obere Metallisierung 18 und auf einer dem Halbleiterelement 4 abgewandten Seite eine untere Metallisierung 20 auf, wobei die obere Metallisierung 18 und die untere Metallisierung 20 beispielsweise aus Kupfer hergestellt sind. Insbesondere ist das erste Substrat 8 als Direct Bonded Copper (DCB) ausgeführt.

Die metallische Wärmesenke 12 weist einen Grundkörper 22 zur flächigen Kontaktierung des Halbleiterelements 4 und beispielhaft eine Rippe 24 auf, wobei die metallische Wärmesenke 12 einstückig aus einem metallischen Werkstoff mit einer Wärmeleitfähigkeit von mindestens 240 W/(m·K) und/oder einer elektrischen Leitfähigkeit von mindestens 40 MS/m hergestellt ist. Insbesondere ist die metallische Wärmesenke 12 aus Kupfer oder einer Kupferlegierung hergestellt. Beispielhaft weist die metallische Wärmesenke 12 ein T-förmiges Querschnittsprofil auf. Während der Grundkörper 22 der metallischen Wärmesenke 12 eine rechteckige Grundfläche aufweist und beispielsweise als Quader ausgeführt ist, kann die Rippe 24 z.B. als Quader, als Zylinder oder als n-eckiges, insbesondere gerades Prisma ausgeführt sein.

Das zweite Substrat 14 ist als mehrlagige Leiterplatte, auch Printed Circuit Board (PCB) genannt, ausgeführt, wobei die Lagen der Leiterplatte eine strukturierte Substratmetallisierung 26 aufweisen. Ferner weist das zweite Substrat 14 eine Aussparung 28 auf, in welcher die Rippe 24 angeordnet ist, wobei der Grundkörper 22 der metallischen Wärmesenke 12 stoffschlüssig mit der Substratmetallisierung 26 des zweiten Substrats 14 verbunden ist. Insbesondere ist die Rippe 24 umlaufend von der Aussparung 28 umgeben, wobei eine Innenkontur der Aussparung 28 an eine Außenkontur der Rippe 24 angepasst ist und wobei die Aussparung 28 über einen, im Wesentlichen konstant breiten, Spalt 30 von der Rippe 24 beabstandet ist. Der Grundkörper 22 der metallischen Wärmesenke 12 weist auf einer dem Halbleiterelement 4 abgewandten Seite eine um die Rippe 24 umlaufende Kontaktfläche 32 auf, über welche die, insbesondere umlaufende, stoffschlüssige Verbindung mit der Substratmetallisierung 26 an einer Unterseite 34 des zweiten Substrats 14 hergestellt wird. Die stoffschlüssige Verbindung der umlaufende Kontaktfläche 32 mit der Substratmetallisierung 26 ist beispielsweise als umlaufender Lötring ausgeführt und verbindet den Kollektorkontakt K über den Grundkörper 22 der metallische Wärmesenke 12 mit dem zweiten Substrat 14. Die Rippe 24 kann bündig mit dem zweiten Substrat 24 abschließen oder über das zweite Substrat 24 hinausstehen. Zwischen der umlaufende Kontaktfläche 32 und der Rippe 24 weist die metallische Wärmesenke 12 eine, insbesondere umlaufende, Nut 36 auf.

Ferner ist zwischen dem ersten Substrat 8 und dem zweiten Substrat 14 ein metallisches Abstandshalteelement 38 angeordnet, welches den Emitterkontakt E des Halbleiterelements 4 elektrisch leitend mit dem zweiten Substrat 14 verbindet. Das metallische Abstandshalteelement 38, welches auch Umsteiger genannt wird, ist beispielsweise aus Kupfer, Aluminium oder einer deren Legierungen hergestellt. Darüber hinaus ist das Halbleiterelement 4 in einem Vergussraum 40 zwischen dem ersten Substrat 8 und dem zweiten Substrat 14 angeordnet, welcher, insbesondere vollständig, durch eine Vergussmasse befüllt ist. Der Vergussraum 40 ist durch die stoffschlüssige Verbindung zwischen der Substratmetallisierung 26 des zweiten Substrats 14 und der umlaufenden Kontaktfläche 32 der metallische Wärmesenke 12 zur Aussparung 28 hin abgedichtet. Das erste Substrat 8 ist überdies, insbesondere stoffschlüssig, mit einer metallischen Grundplatte 42 verbunden, welche beispielsweise als Kühlkörper ausgeführt ist.

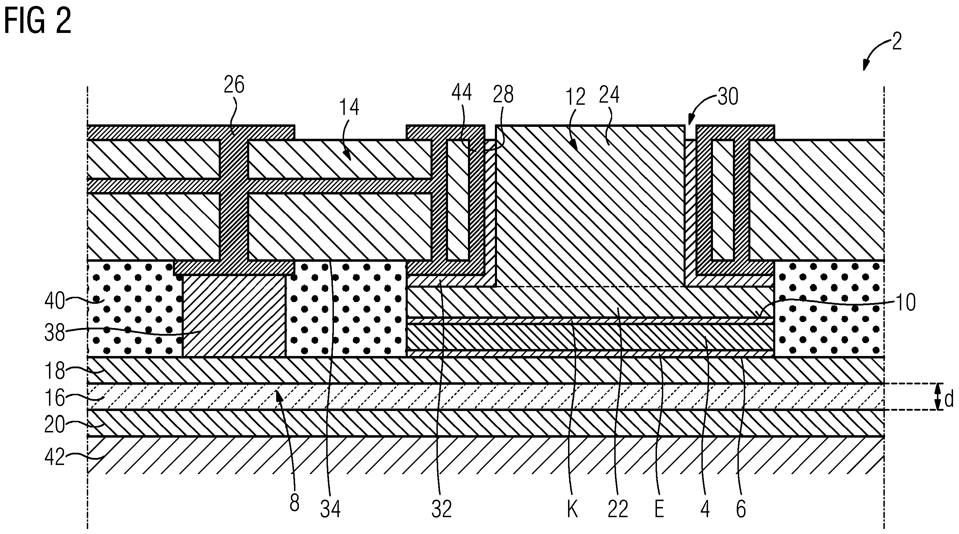

FIG 2 zeigt eine schematische Darstellung einer zweiten Ausgestaltung eines Halbleitermoduls 2 im Querschnitt. Die Aussparung 28 des zweiten Substrats 14 weist eine, insbesondere umlaufende, Kantenmetallisierung 44 auf, über welche beispielsweise das Lot des umlaufenden Lötrings hochsteigen kann, sodass zusätzlich eine stoffschlüssige Verbindung der Kantenmetallisierung 44 zur metallischen Wärmesenke 12 hergestellt wird, was zu einer Vergrößerung der Anbindungsfläche der metallischen Wärmesenke 12 zum zweiten Substrats 14 führt. Die weitere Ausgestaltung des Halbleitermoduls 2 in FIG 2 entspricht der in FIG 1.

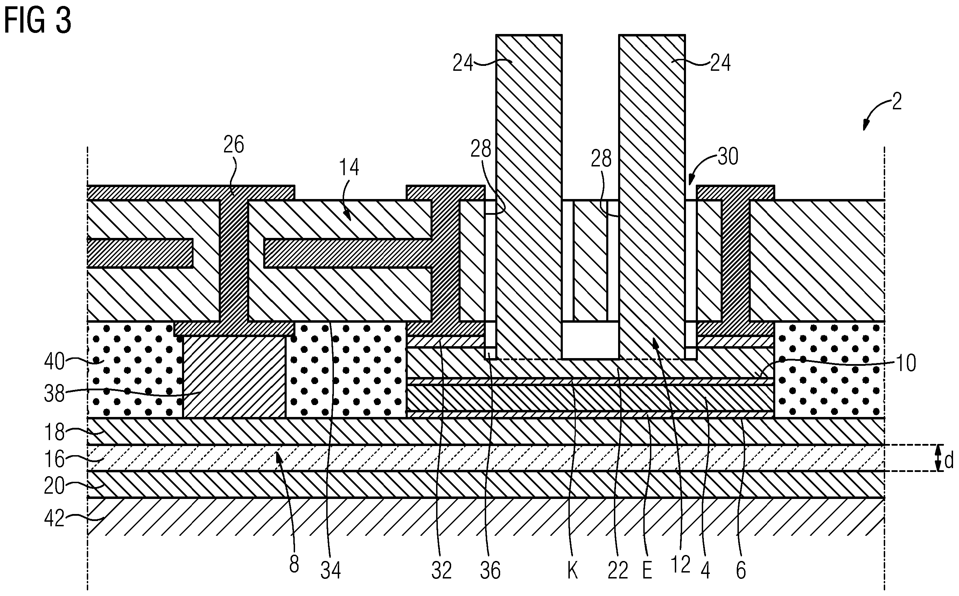

FIG 3 zeigt eine schematische Darstellung einer dritten Ausgestaltung eines Halbleitermoduls 2 im Querschnitt. Die einstückig ausgeführte metallische Wärmesenke 12 weist beispielsweise zwei Rippen 24 auf, welche jeweils in einer Aussparung 28 des zweiten Substrats 14 angeordnet sind. Die metallische Wärmesenke 12 kann jedoch auch z.B. 4, 6, 8 oder 16 Rippen 24 aufweisen, welche insbesondere derartig auf dem Grundkörper 22 angeordnet sind, dass eine gleichmäßige Entwärmung des Halbleiterelements 4 stattfindet. Beispielhaft sind die Rippen 24 identisch, beispielsweise jeweils quaderförmig oder zylinderförmig, ausgeführt und stehen über das zweite Substrat 24 hinaus, sodass im Halbleitermodul 4 entstehende Verlustwärme zumindest teilweise über eine möglichst große Fläche an die umgebende Atmosphäre abgegeben wird.

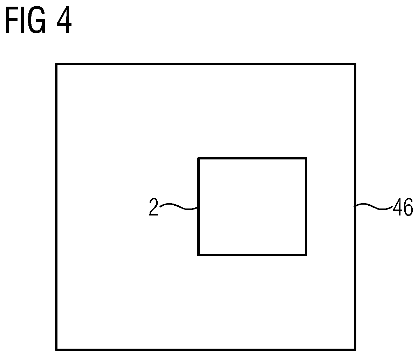

FIG 4 zeigt eine schematische Darstellung eines Stromrichters 46 mit einem Halbleitermodul 2. Der Stromrichter 46 kann mehr als ein Halbleitermodul 2 umfassen.

Zusammenfassend betrifft die Erfindung ein Halbleitermodul 2 mit zumindest einem Halbleiterelement 4, einem ersten Substrat 8 und einem zweiten Substrat 14. Um, im Vergleich zum Stand der Technik, eine höhere Zuverlässigkeit zu erreichen, wird vorgeschlagen, dass das zumindest eine Halbleiterelement 4 auf einer ersten Seite 6 flächig mit dem ersten Substrat 8 und auf einer der ersten Seite 6 abgewandten zweiten Seite 10 flächig mit einer metallischen Wärmesenke 12 kontaktiert ist, wobei die metallische Wärmesenke 12 mit dem Halbleiterelement 4 in einer thermisch leitenden Verbindung steht und elektrisch leitend mit dem zweiten Substrat 14 verbunden ist.

## Patentansprüche

1. Halbleitermodul (2) mit zumindest einem Halbleiterelement (4), einem ersten Substrat (8) und einem zweiten Substrat (14),
wobei das zumindest eine Halbleiterelement (4) auf einer ersten Seite (6) flächig mit dem ersten Substrat (8) und auf einer der ersten Seite (6) abgewandten zweiten Seite (10) flächig mit einer metallischen Wärmesenke (12) kontaktiert ist, wobei die metallische Wärmesenke (12) mit dem Halbleiterelement (4) in einer thermisch leitenden Verbindung steht und elektrisch leitend mit dem zweiten Substrat (14) verbunden ist,
wobei die metallische Wärmesenke (12) einen Grundkörper (22) zur flächigen Kontaktierung des Halbleiterelements (4) und zumindest eine Rippe (24) aufweist,
wobei das zweite Substrat (14) elektrisch leitend mit dem Grundkörper (22) verbunden ist und eine Aussparung (28) aufweist, in welcher die zumindest eine Rippe (24) angeordnet ist,
**dadurch gekennzeichnet, dass**
der Grundkörper (22) eine um die zumindest eine Rippe (24) umlaufende Kontaktfläche (32) aufweist, über welche eine stoffschlüssige Verbindung mit der Substratmetallisierung (26) des zweiten Substrats (14) hergestellt ist,
wobei die umlaufendende Kontaktfläche (32) auf einer dem Halbleiterelement (4) abgewandten Seite des Grundkörpers (22) angeordnet ist.

2. Halbleitermodul (2) nach Anspruch 1,
wobei das Halbleiterelement (4) stoffschlüssig mit der metallischen Wärmesenke (12) verbunden ist und/oder
wobei die metallische Wärmesenke (12) stoffschlüssig mit einer Substratmetallisierung (26) des zweiten Substrats (14) verbunden ist.

3. Halbleitermodul (2) nach einem der Ansprüche 1 oder 2, wobei das Halbleiterelement (4) in einem Vergussraum (40) zwischen dem ersten Substrat (8) und dem zweiten Substrat (14) angeordnet ist und
wobei der Vergussraum (40) durch die stoffschlüssige Verbindung zwischen der Substratmetallisierung (26) des zweiten Substrats (14) und der umlaufenden Kontaktfläche (32) zur Aussparung (28) hin abgedichtet ist.

4. Halbleitermodul (2) nach einem der vorherigen Ansprüche, wobei die Aussparung (28) des zweiten Substrats (14) eine, insbesondere umlaufende, Kantenmetallisierung (44) aufweist, über welche eine stoffschlüssige Verbindung zur metallischen Wärmesenke (12) hergestellt ist.

5. Halbleitermodul (2) nach einem der vorherigen Ansprüche, wobei die metallische Wärmesenke (12) einstückig aus einem metallischen Werkstoff mit einer Wärmeleitfähigkeit von mindestens 240 W/(m·K) und/oder einer elektrischen Leitfähigkeit von mindestens 40 MS/m hergestellt ist.

6. Halbleitermodul (2) nach einem der vorherigen Ansprüche, wobei die metallische Wärmesenke (12) ein T-förmiges Querschnittsprofil aufweist.

7. Stromrichter (46) mit mindestens einem Halbleitermodul (2) nach einem der vorherigen Ansprüche.

8. Verfahren zur Herstellung eines Halbleitermoduls (2) mit zumindest einem Halbleiterelement (4), einem ersten Substrat (8) und einem zweiten Substrat (14),
wobei das zumindest eine Halbleiterelement (4) auf einer ersten Seite (6) flächig mit dem ersten Substrat (8) und auf einer der ersten Seite (6) abgewandten zweiten Seite (10) flächig mit einer metallischen Wärmesenke (12) kontaktiert wird, wobei eine thermisch leitende Verbindung zwischen der metallischen Wärmesenke (12) und dem Halbleiterelement (4) hergestellt wird und
die metallische Wärmesenke (12) elektrisch leitend mit dem zweiten Substrat (14) verbunden wird,
wobei die metallische Wärmesenke (12) einen Grundkörper (22) zur flächigen Kontaktierung des Halbleiterelements (4) und zumindest eine Rippe (24) aufweist,
wobei das zweite Substrat (14) elektrisch leitend mit dem Grundkörper (22) verbunden wird und eine Aussparung (28) aufweist, in welcher die zumindest eine Rippe (24) angeordnet wird,
**dadurch gekennzeichnet, dass**
der Grundkörper (22) eine um die zumindest eine Rippe (24) umlaufende Kontaktfläche (32) aufweist, über welche eine stoffschlüssige Verbindung mit der Substratmetallisierung (26) des zweiten Substrats (14) hergestellt wird,
wobei die umlaufendende Kontaktfläche (32) auf einer dem Halbleiterelement (4) abgewandten Seite des Grundkörpers (22) angeordnet wird.

9. Verfahren nach Anspruch 8, wobei das Halbleiterelement (4) stoffschlüssig mit der metallischen Wärmesenke (12) verbunden wird und/oder wobei die metallische Wärmesenke (12) stoffschlüssig mit einer Substratmetallisierung (26) des zweiten Substrats (14) verbunden wird.

10. Verfahren nach einem der Ansprüche 8 oder 9,
wobei das Halbleiterelement (4) in einem Vergussraum (40) zwischen dem ersten Substrat (8) und dem zweiten Substrat (14) angeordnet wird und
wobei der Vergussraum (40) durch die stoffschlüssige Verbindung zwischen der Substratmetallisierung (26) des zweiten Substrats (14) und der umlaufenden Kontaktfläche (32) zur Aussparung (28) hin abgedichtet wird.

11. Verfahren nach einem der Ansprüche 8 bis 10, wobei die Aussparung (28) des zweiten Substrats (14) eine, insbesondere umlaufende, Kantenmetallisierung (44) aufweist, über welche eine stoffschlüssige Verbindung zur metallischen Wärmesenke (12) hergestellt wird.

## Claims

1. Semiconductor module (2) comprising at least one semiconductor element (4), a first substrate (8) and a second substrate (14),
wherein the at least one semiconductor element (4) is contacted on a first side (6) with the first substrate (8) in a planar manner and is contacted on a second side (10) facing away from the first side (6) with a metallic heat sink (12) in a planar manner,
wherein the metallic heat sink (12) is in thermally conductive connection with the semiconductor element (4) and
is connected to the second substrate (14) in an electrically conductive manner,
wherein the metallic heat sink (12) has a main body (22) for planar contacting of the semiconductor element (4) and at least one fin (24),
wherein the second substrate (14) is connected to the main body (22) in an electrically conductive manner and has a recess (28) in which the at least one fin (24) is arranged, **characterised in that**
the main body (22) has a circumferential contact surface (32) around the at least one fin (24) via which a material-bonded connection is established with the substrate
metallisation (26) of the second substrate (14),
wherein the circumferential contact surface (32) is arranged on a side of the main body (22) facing away from the semiconductor element (4).

2. Semiconductor module (2) according to claim 1,
wherein the semiconductor element (4) is connected to the metallic heat sink (12) in a materially bonded manner and/or wherein the metallic heat sink (12) is connected to a substrate metallisation (26) of the second substrate (14) in a materially bonded manner.

3. Semiconductor module (2) according to one of claims 1 or 2, wherein the semiconductor element (4) is arranged in a potting chamber (40) between the first substrate (8) and the second substrate (14) and
wherein the potting chamber (40) is sealed toward the recess (28) by the material-bonded connection between the substrate metallisation (26) of the second substrate (14) and the circumferential contact surface (32).

4. Semiconductor module (2) according to one of the preceding claims, wherein the recess (28) of the second substrate (14) has edge metallisation (44), in particular circumferential edge metallisation (44), via which a material-bonded connection with the metallic heat sink (12) is established.

5. Semiconductor module (2) according to one of the preceding claims, wherein the metallic heat sink (12) is produced in one piece from a metallic material with a thermal conductivity of at least 240 W/(m·K) and/or an electrical conductivity of at least 40 MS/m.

6. Semiconductor module (2) according to one of the preceding claims, wherein the metallic heat sink (12) has a T-shaped cross-sectional profile.

7. Power converter (46) comprising at least one semiconductor module (2) according to one of the preceding claims.

8. Method for producing a semiconductor module (2) comprising at least one semiconductor element (4), a first substrate (8) and a second substrate (14),
wherein the at least one semiconductor element (4) is contacted on a first side (6) with the first substrate (8) in a planar manner and is contacted on a second side (10) facing away from the first side (6) with a metallic heat sink (12) in a planar manner,
wherein a thermally conductive connection between the metallic heat sink (12) and the semiconductor element (4) is established and
the metallic heat sink (12) is connected to the second substrate (14) in an electrically conductive manner,
wherein the metallic heat sink (12) has a main body (22) for planar contacting of the semiconductor element (4) and at least one fin (24),
wherein the second substrate (14) is connected to the main body (22) in an electrically conductive manner and has a recess (28) in which the at least one fin (24) is arranged, **characterised in that**
the main body (22) has a circumferential contact surface (32) around the at least one fin (24) via which a material-bonded connection is established with the substrate
metallisation (26) of the second substrate (14),
wherein the circumferential contact surface (32) is arranged on a side of the main body (22) facing away from the semiconductor element (4).

9. Method according to claim 8,
wherein the semiconductor element (4) is connected to the metallic heat sink (12) in a materially bonded manner and/or wherein the metallic heat sink (12) is connected to a substrate metallisation (26) of the second substrate (14) in a materially bonded manner.

10. Method according to one of claims 8 or 9,
wherein the semiconductor element (4) is arranged in a potting chamber (40) between the first substrate (8) and the second substrate (14) and
wherein the potting chamber (40) is sealed toward the recess (28) by the material-bonded connection between the substrate metallisation (26) of the second substrate (14) and the circumferential contact surface (32).

11. Method according to one of claims 8 to 10,
wherein the recess (28) of the second substrate (14) has edge metallisation (44), in particular circumferential edge metallisation (44), via which a material-bonded connection to the metallic heat sink (12) is established.

## Revendications

1. Module (2) de semiconducteur comprenant au moins un élément (4) semiconducteur, un premier substrat (8) et un deuxième substrat (14),
dans lequel le au moins un élément (4) semiconducteur est, sur une première face (6), en contact par surface avec le premier substrat (8) et, sur une deuxième face (10) loin de la première face (6), en contact par surface avec un puits (12) de chaleur métallique, dans lequel le puits (12) de chaleur est en liaison d'une manière conductrice thermiquement avec l'élément (4) semiconducteur et est connecté d'une manière conductrice de l'électricité au deuxième substrat (14),
dans lequel le puits (12) de chaleur métallique a un corps (22) de base pour la mise en contact par surface de l'élément (4) à semiconducteur et au moins une nervure (24),
dans lequel le deuxième substrat (14) est connecté d'une manière conductrice de l'électricité au corps (22) de base et a un évidement (28), dans lequel est disposé la au moins une nervure (24),
**caractérisé en ce que**
le corps (22) de base a, faisant le tour autour de la au moins une nervure (24), une surface (32) de contact, par laquelle est ménagée une liaison à coopération de matière avec la métallisation (26) du deuxième substrat (14),
dans lequel la surface (32) de contact faisant le tour est disposée sur une face du corps (22) de base non tournée vers l'élément (4) semiconducteur.

2. Module (2) de semiconducteur suivant la revendication 1, dans lequel l'élément (4) semiconducteur est relié à coopération de matière avec le puits (12) de chaleur métallique et /ou dans lequel le puits (12) de chaleur métallique est relié à coopération de matière avec une métallisation (26) du deuxième substrat (14).

3. Module (2) de semiconducteur suivant l'une des revendications 1 ou 2,
dans lequel l'élément (4) semiconducteur est disposé dans un espace (40) de coulée entre le premier substrat (8) et le deuxième substrat (14) et
dans lequel l'espace (40) de coulée est rendu étanche en direction de l'évidement (28) par la liaison à coopération de matière entre la métallisation (26) du deuxième substrat (14) et la surface (32) de contact faisant le tour.

4. Module (2) de semiconducteur suivant l'une des revendications précédentes,
dans lequel l'évidement (28) du deuxième substrat (14) a une métallisation (44) de bord, en particulier faisant le tour, par laquelle une liaison à coopération de matière est ménagée avec le puits (12) de chaleur métallique.

5. Module (2) de semiconducteur suivant l'une des revendications précédentes,
dans lequel le puits (12) de chaleur métallique est fabriqué d'une seule pièce en un matériau métallique ayant une conductibilité thermique d'au moins 240 W /(m·K) et /ou une conductivité électrique d'au moins 40 MS /m.

6. Module (2) de semiconducteur suivant l'une des revendications précédentes,
dans lequel le puits (12) de chaleur métallique a un profil de section transversal en forme de T.

7. Convertisseur (46) comprenant au moins un module (2) de semiconducteur suivant l'une des revendications précédentes.

8. Procédé de fabrication d'un module (2) de semiconducteur comprenant au moins un élément (4) semiconducteur, un premier substrat (8) et un deuxième substrat (14),
dans lequel le au moins un élément (4) semiconducteur est, sur une première face (6) par surface avec le premier substrat (8) et sur une deuxième face (10) non tournée vers la première face (6) par surface en contact avec un puits (12) de chaleur métallique,
dans lequel on ménage une liaison conductrice thermiquement entre le puits (12) de chaleur métallique et l'élément (4) semiconducteur et
on relie le puits (12) de chaleur métallique d'une manière conductrice de l'électricité au deuxième substrat (14),
dans lequel le puits (12) de chaleur métallique a un corps (22) de base pour la mise en contact par surface de l'élément (4) semiconducteur et au moins une nervure (24),
dans lequel le deuxième substrat (14) est connecté d'une manière conductrice de l'électricité au corps (22) de base et a un évidement (28), dans lequel est disposé la au moins une nervure (24),
**caractérisé en ce que**
le corps (22) de base a, faisant le tour autour de la au moins une nervure (24), une surface (32) de contact, par laquelle est ménagée une liaison à coopération de matière avec la métallisation (26) du deuxième substrat (14), dans lequel la surface (32) de contact faisant le tour est disposée sur une face du corps (22) de base non tournée vers l'élément (4) conducteur.

9. Procédé suivant la revendication 8,
dans lequel on relie à coopération de matière l'élément (4) semiconducteur au puits (12) de chaleur métallique et/ou
dans lequel on relie à coopération de matière le puits (12) de chaleur métallique à une métallisation (26) du deuxième substrat (14).

10. Procédé suivant l'une des revendications 8 à 9,
dans lequel on met l'élément (4) semiconducteur dans un espace (40) de coulée, entre le premier substrat (8) et le deuxième substrat (14) et
dans lequel on rend étanche, en direction de l'évidement (28), l'espace (40) de coulée par liaison à coopération de matière entre la métallisation (26) du deuxième substrat (14) et la surface (32) de contact faisant le tour.

11. Procédé suivant l'une des revendications 8 à 10,
dans lequel l'évidement (28) du deuxième substrat (14) a une métallisation (44) de bord, en particulier faisant le tour, par laquelle on ménage une liaison à coopération de matière avec le puits (12) de chaleur métallique.
